# EUROPEAN PATENT APPLICATION

(11) **EP 4 783 386 A1**
(43) Date of publication of application: **29.07.2026**
(21) Application number: 25218509.5
(22) Date of filing: 25.11.2025
(51) Int. Cl.: H02B 1/56

(54) **POWER CABINET ELECTRONICS VENTING**

(30) Priority: 24.01.2025 US 202563749460 P; 29.10.2025 US 202519373694
(71) Applicant: Vertiv Corporation, Westerville, OH 43082 (US)
(72) Inventor: CALDWELL, Carl, Westerville, 43082 (US); STRAIN, Michael, Westerville, 43082 (US)
(74) Representative: Bryn-Jacobsen, Caelia

(57) **Abstract**

A power distribution panel can include a cabinet, one or more breakers disposed within the cabinet for selectively providing power to a plurality of computer equipment devices, a door coupled to the cabinet for selectively providing access to the breakers, and a user interface for providing information about the breakers. The user interface can be coupled to the door and/or can provide information about the breakers at the front of the cabinet, such as through the door. The power distribution panel can include a first airflow path across the breakers and a second airflow path across the user interface. The first airflow path can be isolated from the second airflow path.

## Description

### CROSS REFERENCE TO RELATED APPLICATIONS

This application claims the benefit of U.S. Provisional Patent Application No. 63/749,460 filed January 24, 2025. This application is related to those certain commonly owned applications entitled Reconfigurable Power Panel, Hinged Panelboard Assembly, and Power-Flexible Panelboard Cabinet, respectively, filed on even date hereof.

### TECHNICAL FIELD

The present disclosure relates generally to data center power equipment and more specifically relates to cooling cabinets housing such power equipment.

### BACKGROUND

As data centers grow, their power demands increase, requiring more and larger power distribution devices. Heat generated by power distribution devices can be detrimental to monitoring devices that monitor such power distribution devices and/or other equipment typically exposed to such heat.

### SUMMARY

Applicant has created new and useful devices, systems and methods for cooling cabinets that house data center power equipment. In at least one example, a power distribution panel according to the disclosure can provide cooling air to monitoring devices that monitor power distribution devices and/or other equipment. In at least one example, a power distribution panel according to the disclosure can isolate the cooling air provided to the monitoring devices from the power distribution devices and/or other equipment, and/or from the cooling air provided to such equipment. In at least one example, a power distribution panel according to the disclosure can ensure proper cooling of monitoring devices by isolating them and/or their cooling airflow from other heat sources, such as the power distribution equipment they monitor.

In at least one example, a power distribution panel according to the disclosure can include a cabinet, one or more breakers disposed within the cabinet, a door coupled to the cabinet for selectively providing access to the breakers, a user interface for providing information about the breakers, or any combination thereof. In at least one example, the cabinet can be similar to those used in data centers to house computer equipment devices, such as servers, and/or be similarly sized. In at least one example, the cabinet can have a front, back, top, bottom, one or more sides, or any combination thereof. In at least one example, the door can be coupled to the front of the cabinet. In at least one example, the breakers can selectively provide power to a plurality of computer equipment devices, which can be disposed inside the cabinet and/or outside the cabinet, such as in one or more other cabinets. In at least one example, the user interface can be coupled to the door and/or provide the information about the breakers, and/or control thereof, at the front of the cabinet, such as through the door. In at least one example, a power distribution panel according to the disclosure can include a first airflow path across the breakers and/or a second airflow path across the user interface. In at least one example, the first airflow path can be isolated from the second airflow path.

In at least one example, the first airflow path can be into the cabinet, across the breakers, and out of the cabinet. In at least one example, the first airflow path can enter and/or exit the cabinet from the front and/or through the door. In at least one example, the first airflow path can enter the cabinet and/or the door below the second airflow path and/or exit the cabinet and/or the door above the second airflow path. In at least one example, the second airflow path can be into the cabinet, across the user interface, and out of the cabinet. In at least one example, the second airflow path can enter and/or exit the cabinet from the front and/or through the door.

In at least one example, a power distribution panel according to the disclosure can include a heat shield for thermally isolating the user interface from the breakers. In at least one example, the heat shield can be coupled to the door between the user interface and the breakers.

In at least one example, the door can be or include an outer door and/or an inner door. In at least one example, the inner door can insulate the user interface from an interior space of the cabinet in which the breakers can be disposed. In at least one example, the inner door can insulate the second airflow path from the first airflow path. In at least one example, the user interface can be coupled to the inner door and/or the outer door.

In at least one example, the door, such as the inner door and/or the outer door, can include a chamber. In at least one example, the chamber can be isolated from an interior space of the cabinet in which the breakers can be disposed. In at least one example, the user interface can be disposed at least partially within the chamber. In at least one example, the first airflow path can enter the cabinet and/or the door below the chamber and/or exit the cabinet above the chamber. In at least one example, the second airflow path can enter the chamber above the first airflow path and/or exit the chamber below the first airflow path.

In at least one example, the breakers can be cooled by air flowing along the first airflow path through natural and/or forced convection. In at least one example, the user interface can be cooled by air flowing along the second airflow path through natural and/or forced convection. In at least one example, the power distribution panel can include one or more fans and/or blowers to selectively induce airflow along the first airflow path and/or the second airflow path.

### BRIEF DESCRIPTION OF THE DRAWINGS

FIG. 1 is a side sectional view of one of many examples of a power distribution panel according to the disclosure.
FIG. 2 is a perspective view of one of many examples of a power distribution panel according to the disclosure.
FIG. 3 is a perspective view of one of many examples of a user interface module of a power distribution panel according to the disclosure.
FIG. 4 is another perspective view of one of many examples of a power distribution panel according to the disclosure.
FIG. 5 is a simplified side sectional view of one of many examples of a power distribution panel according to the disclosure.
FIG. 6 is a simplified front elevation view of a plurality of cabinets for use with a power distribution panel according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art. Persons of skill in this art will also appreciate that the development of an actual commercial example incorporating aspects will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood the disclosures taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for cooling cabinets that house data center power equipment. In at least one example, a power distribution panel according to the disclosure can provide cooling air to monitoring devices that monitor power distribution devices and/or other equipment. In at least one example, a power distribution panel according to the disclosure can isolate the cooling air provided to the monitoring devices from the power distribution devices and/or other equipment, and/or from the cooling air provided to such equipment. In at least one example, a power distribution panel according to the disclosure can ensure proper cooling of monitoring devices by isolating them and/or their cooling airflow from other heat sources, such as the power distribution equipment they monitor.

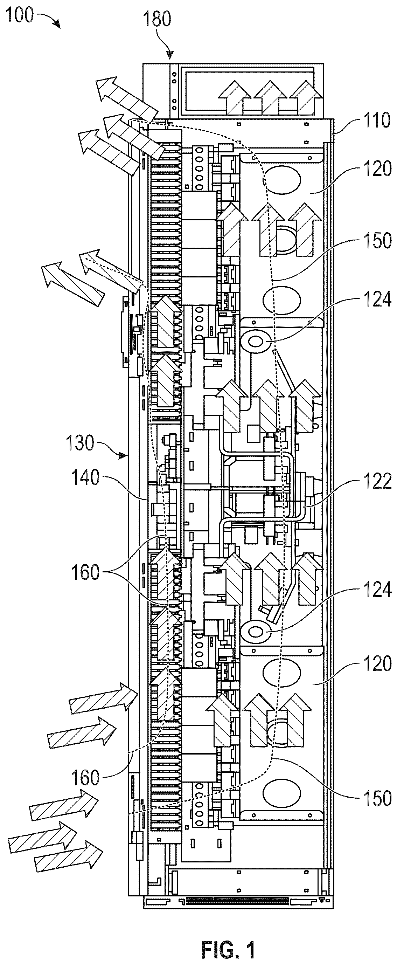

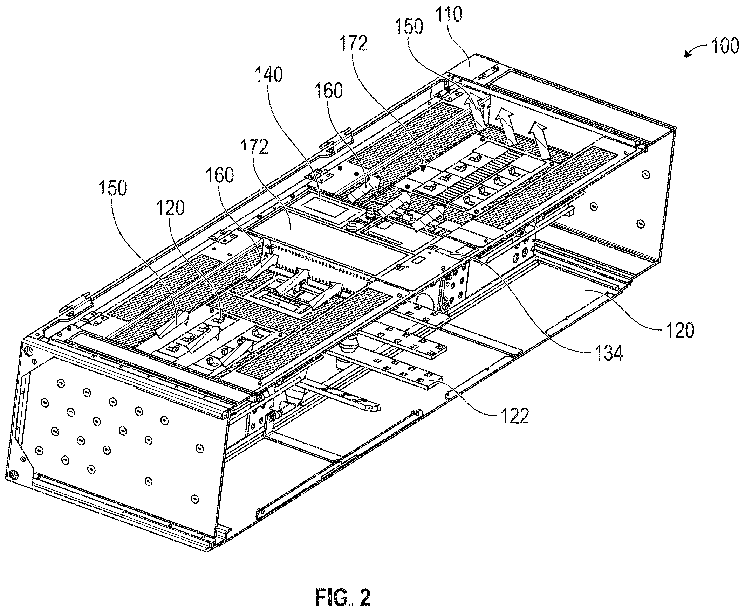

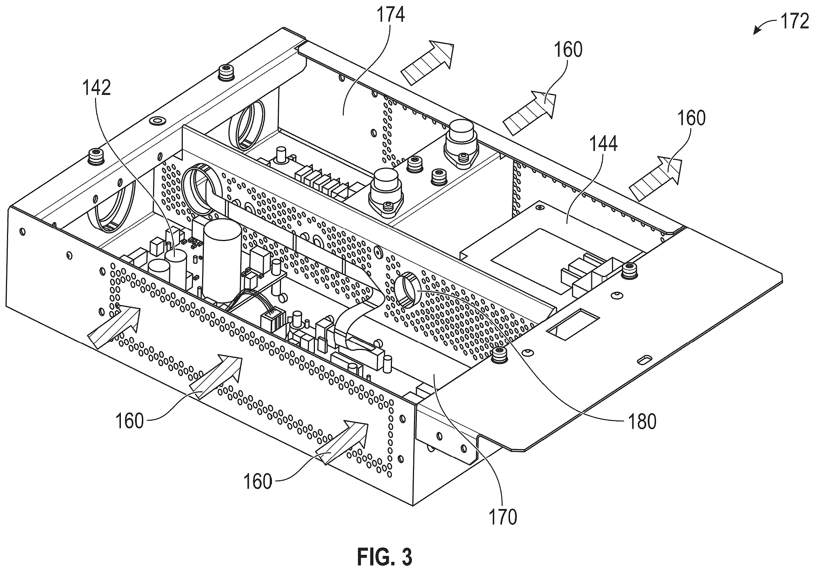

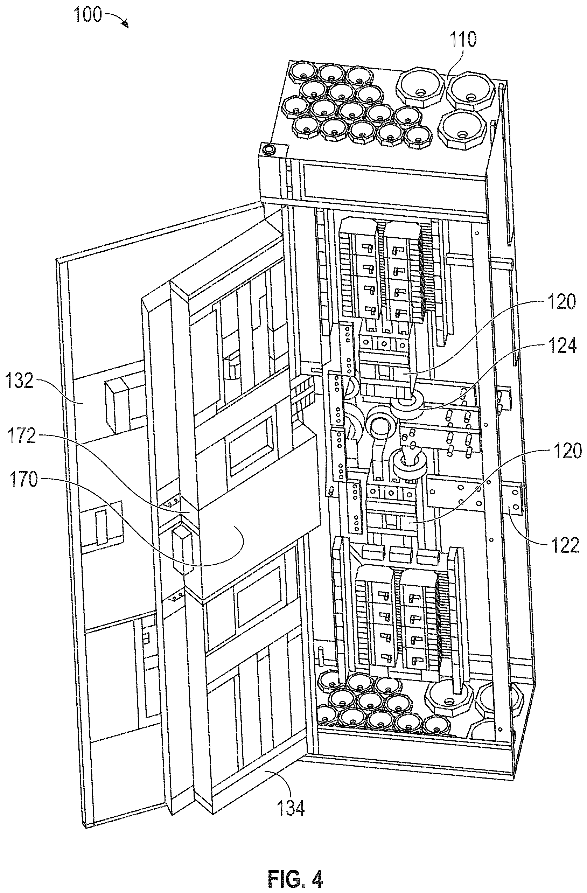

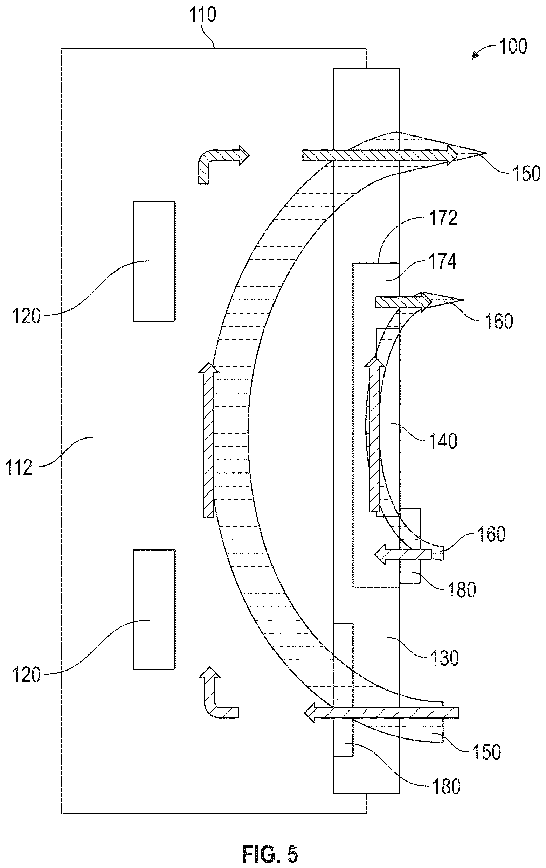

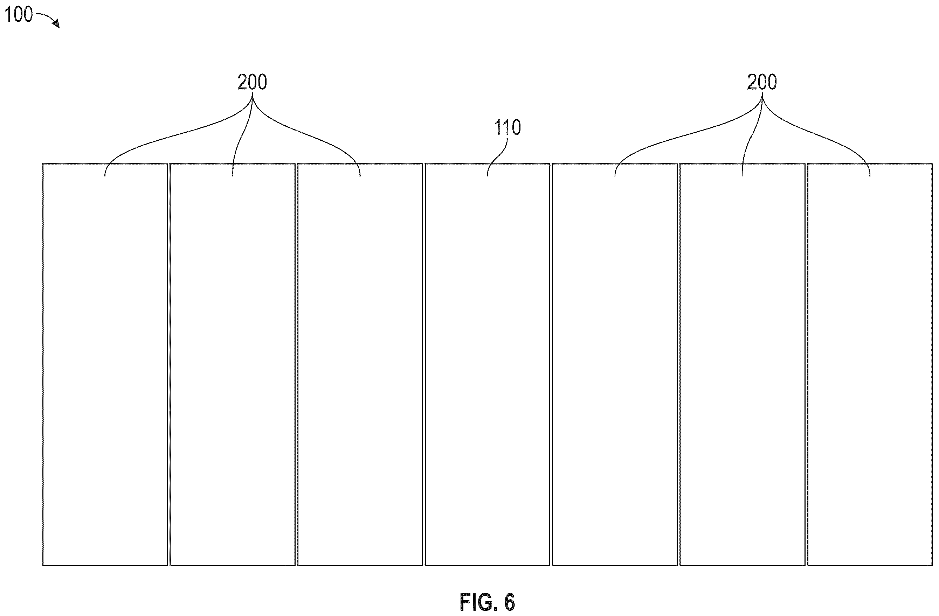

FIG. 1 is a side sectional view of one of many examples of a power distribution panel according to the disclosure. FIG. 2 is a perspective view of one of many examples of a power distribution panel according to the disclosure. FIG. 3 is a perspective view of one of many examples of a user interface module of a power distribution panel according to the disclosure. FIG. 4 is another perspective view of one of many examples of a power distribution panel according to the disclosure. FIG. 5 is a simplified side sectional view of one of many examples of a power distribution panel according to the disclosure. FIG. 6 is a simplified front elevation view of a plurality of cabinets for use with a power distribution panel according to the disclosure. FIGS. 1-6 are described in conjunction with one another.

In at least one example, a power distribution panel 100 according to the disclosure can include one or more cabinets 110, such as a housing or other enclosure, one or more breakers 120 disposed within the cabinet 110, one or more doors 130 coupled to the cabinet 110 for selectively providing access to the breakers 120, one or more user interfaces 140 for providing information about the breakers 120, or any combination thereof.

In at least one example, the cabinet 110 can be the same as or similar to computer equipment cabinets 200 used in data centers to house computer equipment devices, such as servers. In at least one example, the cabinet 110 can be the same size as such computer equipment cabinets 200 and/or can be similarly sized. In at least one example, the cabinet 110 can be arranged for being coupled to a wall in a data center having one or more computer equipment cabinets 200. In at least one example, the cabinet 110 can have a front, back, top, bottom, one or more sides, or any combination thereof. In at least one example, the door 130 can be coupled to the front of the cabinet 110. In at least one example, the door 130 can include a plurality of perforations, or other vents, for allowing air to flow into and/or out of the cabinet 110 through the door 130.

In at least one example, the breakers 120 can selectively provide or otherwise distribute power to one or more computer equipment devices, such as computer equipment devices disposed in one or more computer equipment cabinets 200. In at least one example, one or more computer equipment devices can be at least partially disposed inside the cabinet 110. In at least one example, one or more computer equipment devices can be at least partially disposed outside the cabinet 110, such as in one or more computer equipment cabinets 200. In at least one example, a power distribution panel 100 according to the disclosure can include one or more busbars 122 for providing power to and/or receiving power from the breakers 120. In at least one example, a power distribution panel 100 according to the disclosure can include one or more current transformers (CTs) 124 for transforming power to and/or power from the breakers 120.

In at least one example, the user interface 140 can be coupled to the door 130 and/or provide information about the breakers 120 at the front of the cabinet 110, such as through the door 130. In at least one example, the user interface 140 can include one or more circuit boards 142 for monitoring the breakers 120 and/or the CTs 124. In at least one example, the user interface 140 can include one or more audio and/or video indicators, such as a touchscreen display 144, for providing information about the breakers 120, such as their operating status and/or the power flowing to and/or from the breakers 120. In at least one example, the user interface 140 can be coupled to and/or be part of a supervisory control system for the data center. In at least one example, the user interface 140 can provide for control of one or more operational aspects of the breakers 120, such as via commands from the supervisory control system and/or a user.

In at least one example, a power distribution panel 100 according to the disclosure can include a first (or other) airflow path 150 across the breakers 120 for cooling the breakers 120 and/or a second (or other) airflow path 160 across the user interface 140 for cooling the user interface 140. In at least one example, the first airflow path 150 can flow across a first type of equipment, in addition to or instead of the breakers 120, and/or the second airflow path 160 can flow across a second, different type of equipment, in addition to or instead of the user interface 140. In at least one example, the first airflow path 150 can be at least partially isolated from the second airflow path 160, such as by way of one or more walls, panels and/or other structures for routing airflow.

In at least one example, the first airflow path 150 can be into the cabinet 110, across the breakers 120 and/or the first type of equipment, and out of the cabinet 110. In at least one example, the first airflow path 150 can enter and/or exit the cabinet 110 from the front and/or through the door 130. In at least one example, the first airflow path 150 can enter the cabinet 110 and/or the door 130 below the second airflow path 160 and/or exit the cabinet 110 and/or the door 130 above the second airflow path 160. In at least one example, the first airflow path 150 can enter the cabinet 110 from the bottom, or adjacent the bottom, and/or exit the cabinet 110 from the top, or near the top, such as in the middle of and/or towards the back of the cabinet 110.

In at least one example, the second airflow path 160 can be into the cabinet 110, across the user interface 140 and/or the second type of equipment, and out of the cabinet 110. In at least one example, the second airflow path 160 can enter and/or exit the cabinet 110 from the front and/or through the door 130. In at least one example, the second airflow path 160 can enter the cabinet 110 and/or the door 130 above the first airflow path 150 and/or exit the cabinet 110 and/or the door 130 below the first airflow path 150. In at least one example, the second airflow path 160 can enter the cabinet 110 from the bottom, or adjacent the bottom, and/or exit the cabinet 110 from the top, or near the top, such as towards the front of the cabinet 110.

In at least one example, a power distribution panel 100 according to the disclosure can include one or more heat shields 170 for thermally isolating the user interface 140 and/or the second type of equipment from the breakers 120 and/or the first type of equipment. In at least one example, the heat shield 170 can be coupled to the door 130 between the user interface 140, and/or the second type of equipment, and the breakers 120, and/or the first type of equipment. In at least one example, the heat shield 170 can reflect heat from the breakers 120 and/or other equipment in an interior space 112 of the cabinet 110 and/or otherwise insulate the user interface from the heat generated by the breakers 120, the busbars 122, the CTs 124, other equipment in the interior space 112 of the cabinet 110, or any combination thereof.

In at least one example, the door 130 can be or include an outer door 132 and/or an inner door 134. In at least one example, the inner door 134 can insulate the user interface 140 and/or the second type of equipment from the interior space 112 of the cabinet 110 in which the breakers 120 and/or the first type of equipment can be disposed. In at least one example, the inner door 134 can insulate the second airflow path 160 from the first airflow path 150. In at least one example, the user interface 140 can be coupled to the inner door 134 and/or the outer door 132.

In at least one example, the door 130, such as the inner door 134 and/or the outer door 132, can include or receive a module 172 that houses or includes the user interface 140. In at least one example, the heat shield 170 can be part of a module 172 that houses or includes the user interface 140. In at least one example, the heat shield 170 and/or the module 172 can define a chamber 174 in which the user interface 140 can be at least partially disposed. In at least one example, the chamber 174 can be isolated from the interior space 112 of the cabinet 110 in which the breakers 120 and/or the first type of equipment can be disposed. In at least one example, the user interface 140 and/or the second type of equipment, or a portion thereof, can be disposed at least partially within the chamber 174. In at least one example, the first airflow path 150 can enter the cabinet 110 and/or the door 130 below the chamber 174 and/or exit the cabinet 110 and/or the door 130 above the chamber 174. In at least one example, the second airflow path 160 can enter the chamber 174 above the first airflow path 150 and/or exit the chamber 174 below the first airflow path 150.

In at least one example, the breakers 120, the busbars 122, the CTs 124, the first type of equipment, other equipment in the interior space 112 of the cabinet 110, or any combination thereof, can be cooled by air flowing along the first airflow path 150 through natural and/or forced convection. In at least one example, the user interface 140 and/or the second type of equipment can be cooled by air flowing along the second airflow path 160 through natural and/or forced convection. In at least one example, the power distribution panel 100 can include one or more air movers 180, such as fans, blowers, other air movers, or any combination thereof, for selectively inducing airflow along the first airflow path 150 and/or the second airflow path 160.

In at least one example, a power distribution panel according to the disclosure can include a cabinet, one or more breakers disposed within the cabinet, a door coupled to the cabinet for selectively providing access to the breakers, a user interface for providing information about the breakers, or any combination thereof. In at least one example, the cabinet can be similar to those used in data centers to house computer equipment devices, such as servers, and/or be similarly sized. In at least one example, the cabinet can have a front, back, top, bottom, one or more sides, or any combination thereof. In at least one example, the door can be coupled to the front of the cabinet. In at least one example, the breakers can selectively provide power to a plurality of computer equipment devices, which can be disposed inside the cabinet and/or outside the cabinet, such as in one or more other cabinets. In at least one example, the user interface can be coupled to the door and/or provide the information about the breakers, and/or control thereof, at the front of the cabinet, such as through the door. In at least one example, a power distribution panel according to the disclosure can include a first airflow path across the breakers and/or a second airflow path across the user interface. In at least one example, the first airflow path can be isolated from the second airflow path.

In at least one example, the first airflow path can be into the cabinet, across the breakers, and out of the cabinet. In at least one example, the first airflow path can enter and/or exit the cabinet from the front and/or through the door. In at least one example, the first airflow path can enter the cabinet and/or the door below the second airflow path and/or exit the cabinet and/or the door above the second airflow path. In at least one example, the second airflow path can be into the cabinet, across the user interface, and out of the cabinet. In at least one example, the second airflow path can enter and/or exit the cabinet from the front and/or through the door.

In at least one example, a power distribution panel according to the disclosure can include a heat shield for thermally isolating the user interface from the breakers. In at least one example, the heat shield can be coupled to the door between the user interface and the breakers.

In at least one example, the door can be or include an outer door and/or an inner door. In at least one example, the inner door can insulate the user interface from an interior space of the cabinet in which the breakers can be disposed. In at least one example, the inner door can insulate the second airflow path from the first airflow path. In at least one example, the user interface can be coupled to the inner door and/or the outer door.

In at least one example, the door, such as the inner door and/or the outer door, can include a chamber. In at least one example, the chamber can be isolated from an interior space of the cabinet in which the breakers can be disposed. In at least one example, the user interface can be disposed at least partially within the chamber. In at least one example, the first airflow path can enter the cabinet and/or the door below the chamber and/or exit the cabinet above the chamber. In at least one example, the second airflow path can enter the chamber above the first airflow path and/or exit the chamber below the first airflow path.

In at least one example, the breakers can be cooled by air flowing along the first airflow path through natural and/or forced convection. In at least one example, the user interface can be cooled by air flowing along the second airflow path through natural and/or forced convection. In at least one example, the power distribution panel can include one or more fans and/or blowers to selectively induce airflow along the first airflow path and/or the second airflow path.

Other and further examples utilizing one or more aspects of the disclosure can be devised without departing from the Applicant's disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1.A power distribution panel comprising:
   a cabinet having a front, back, top, and bottom;
   a plurality of breakers disposed within the cabinet configured to selectively provide power to a plurality of computer equipment devices;
   a first airflow path into the cabinet, across the breakers, and out of the cabinet;
   a door coupled to the front of the cabinet and configured to selectively provide access to the breakers;
   a user interface coupled to the door and configured to provide, at the front of the cabinet, information about the breakers; and
   a second airflow path into the cabinet, across the user interface, and out of the cabinet; wherein the first airflow path is isolated from the second airflow path.
2.The power distribution panel as set forth in clause 1, wherein the first airflow path enters and exits the cabinet from the front.
3.The power distribution panel as set forth in any one of the preceding clauses, wherein the first airflow path enters and exits the cabinet through the door.
4.The power distribution panel as set forth in any one of the preceding clauses, wherein the second airflow path enters and exits the cabinet from the front.
5.The power distribution panel as set forth in any one of the preceding clauses, wherein the second airflow path enters and exits the cabinet through the door.
6.The power distribution panel as set forth in any one of the preceding clauses, wherein both airflow paths enter and exit the cabinet from the front.
7.The power distribution panel as set forth in any one of the preceding clauses, wherein both airflow paths enter and exit the cabinet through the door.
8.The power distribution panel as set forth in clause 7, wherein the first airflow path enters the door below the second airflow path.
9.The power distribution panel as set forth in clause 7, wherein the first airflow path exits the door above the second airflow path.
10.The power distribution panel as set forth in any one of the preceding clauses, further comprising a heat shield configured to thermally isolate the user interface from the breakers.
11.The power distribution panel as set forth in clause 10, wherein the heat shield is coupled to the door between the user interface and the breakers.
12.The power distribution panel as set forth in any one of the preceding clauses, wherein the door is an outer door; and further comprising an inner door configured to insulate the user interface from an interior space of the cabinet in which the breakers are disposed.
13.The power distribution panel as set forth in any one of the preceding clauses, wherein the door comprises a chamber; wherein the chamber is isolated from an interior space of the cabinet in which the breakers are disposed; and wherein the user interface is disposed within the chamber.
14.The power distribution panel as set forth in clause 13, wherein the first airflow path enters the cabinet below the chamber.
15.The power distribution panel as set forth in clause 13, wherein the first airflow path exits the cabinet above the chamber.
16. The power distribution panel as set forth in clause 13, wherein the first airflow path enters the door below the chamber.
17.The power distribution panel as set forth in clause 13, wherein the first airflow path exits the door above the chamber.
18.The power distribution panel as set forth in any one of the preceding clauses, wherein the breakers are cooled by air flowing along the first airflow path through natural convection; and wherein the user interface is cooled by air flowing along the second airflow path through natural convection.
19.The power distribution panel as set forth in any one of the preceding clauses, wherein the breakers are cooled by air flowing along the first airflow path through forced convection; and wherein the user interface is cooled by air flowing along the second airflow path through natural convection.
20.The power distribution panel as set forth in any one of the preceding clauses, wherein the breakers are cooled by air flowing along the first airflow path through natural convection; and wherein the user interface is cooled by air flowing along the second airflow path through forced convection.
21. The power distribution panel as set forth in any one of clauses 1-20, wherein the breakers are cooled by air flowing along the first airflow path through forced convection; and wherein the user interface is cooled by air flowing along the second airflow path through forced convection.
22. The power distribution panel as set forth in any one of the previous clauses, wherein the computer equipment devices are disposed outside the cabinet.
23. A method as shown and/or described herein.
24. A system as shown and/or described herein.
25. A device as shown and/or described herein.

Obvious modifications and alterations to the described examples are available to those of ordinary skill in the art having the benefits of the present disclosure. The disclosed and undisclosed examples are not intended to limit or restrict the scope or applicability conceived of by the Applicant, but rather, in conformity with the patent laws, Applicant intends to fully protect all such modifications and improvements that come within the scope or range of equivalents of the following claims.

## Claims

1. A power distribution panel comprising:
a cabinet having a front, back, top, and bottom;
a plurality of breakers disposed within the cabinet configured to selectively provide power to a plurality of computer equipment devices;
a first airflow path into the cabinet, across the breakers, and out of the cabinet;
a door coupled to the front of the cabinet and configured to selectively provide access to the breakers;
a user interface coupled to the door and configured to provide, at the front of the cabinet, information about the breakers; and
a second airflow path into the cabinet, across the user interface, and out of the cabinet;
wherein the first airflow path is isolated from the second airflow path.

2. The power distribution panel as set forth in claim 1, wherein the first airflow path enters and exits the cabinet from the front.

3. The power distribution panel as set forth in any one of the preceding claims, wherein the first airflow path enters and exits the cabinet through the door.

4. The power distribution panel as set forth in any one of the preceding claims, wherein the second airflow path enters and exits the cabinet from the front.

5. The power distribution panel as set forth in any one of the preceding claims, wherein the second airflow path enters and exits the cabinet through the door.

6. The power distribution panel as set forth in any one of the preceding claims, wherein both airflow paths enter and exit the cabinet from the front.

7. The power distribution panel as set forth in any one of the preceding claims, wherein both airflow paths enter and exit the cabinet through the door.

8. The power distribution panel as set forth in claim 7, wherein the first airflow path enters the door below the second airflow path.

9. The power distribution panel as set forth in claim 7, wherein the first airflow path exits the door above the second airflow path.

10. The power distribution panel as set forth in any one of the preceding claims, further comprising a heat shield configured to thermally isolate the user interface from the breakers.

11. The power distribution panel as set forth in claim 10, wherein the heat shield is coupled to the door between the user interface and the breakers.

12. The power distribution panel as set forth in any one of the preceding claims, wherein the door is an outer door; and further comprising an inner door configured to insulate the user interface from an interior space of the cabinet in which the breakers are disposed.

13. The power distribution panel as set forth in any one of the preceding claims, wherein the door comprises a chamber; wherein the chamber is isolated from an interior space of the cabinet in which the breakers are disposed; and wherein the user interface is disposed within the chamber.

14. The power distribution panel as set forth in claim 13, wherein the first airflow path enters the cabinet below the chamber; or optionally
wherein the first airflow path exits the cabinet above the chamber; or optionally
wherein the first airflow path enters the door below the chamber; or optionally
wherein the first airflow path exits the door above the chamber.

15. The power distribution panel as set forth in any one of the preceding claims, wherein the breakers are cooled by air flowing along the first airflow path through natural convection; and wherein the user interface is cooled by air flowing along the second airflow path through natural convection; or optionally
wherein the breakers are cooled by air flowing along the first airflow path through forced convection; and wherein the user interface is cooled by air flowing along the second airflow path through natural convection; or optionally
wherein the breakers are cooled by air flowing along the first airflow path through natural convection; and wherein the user interface is cooled by air flowing along the second airflow path through forced convection.
